(19) **Europäisches Patentamt / European Patent Office / Office européen des brevets**

(11) **EP 0 998 003 B1**

(12) **FASCICULE DE BREVET EUROPEEN**

(45) Date de publication et mention
de la délivrance du brevet:
**03.03.2010 Bulletin 2010/09**

(51) Int Cl.:
***H02H 3/33*** *(2006.01)*

(21) Numéro de dépôt: **99410125.1**

(22) Date de dépôt: **05.10.1999**

(54) **Dispositif de protection différentielle comportant un circuit test multitension**

Differentialschutz mit Mehrfachspannungsprüfkreis

Differential protection device with multiple-voltage test circuit

(84) Etats contractants désignés:
**DE ES GB IT**

(30) Priorité: **30.10.1998 FR 9813880**

(43) Date de publication de la demande:
**03.05.2000 Bulletin 2000/18**

(73) Titulaire: **Schneider Electric Industries SAS**
**92500 Rueil-Malmaison (FR)**

(72) Inventeurs:
• **Paupert, Marc**
**38050 Grenoble Cedex 09 (FR)**
• **Cador, Nicolas**
**38050 Grenoble Cedex 09 (FR)**

(74) Mandataire: **Tripodi, Paul et al**
**Schneider Electric Industries SAS**
**Service Propriété Industrielle**
**World Trade Center / 38EE1**
**5 Place Robert Schuman**
**38050 Grenoble Cedex 09 (FR)**

(56) Documents cités:
**DE-A- 2 658 958      GB-A- 2 269 064**

**Description**

L'invention concerne un dispositif de protection différentielle comportant un transformateur-sommateur, connecté à des moyens de déclenchement, et un circuit test comportant, en série entre deux conducteurs d'un réseau à protéger, une résistance de test, un interrupteur de test, normalement ouvert, et au moins un enroulement auxiliaire du transformateur-sommateur.

Dans les dispositifs de protection différentielle connus (FR 1.318.856, US 3.943.409) dans lesquels le circuit test comporte, en série, une résistance, un bouton-test et un enroulement auxiliaire, il est nécessaire d'adapter la valeur de la résistance du circuit test en fonction de la tension d'alimentation du dispositif. Dans la pratique, la conception de dispositifs de protection différentielle destinés à être utilisés avec des tensions d'alimentation de 127V, 220V et 415V nécessite au moins deux circuits tests différents.

Le brevet US 4.091.431 décrit un circuit test comportant, en série, un potentiomètre et un bouton-test. Un tel circuit permet, dans une certaine mesure, de s'affranchir de la tension, mais nécessite un réglage manuel de chaque dispositif en fonction de la tension d'alimentation associée.

Un autre dispositif de protection différentielle multitension est connu du document GB-A-2 269 064.

L'invention a pour but un dispositif dans lequel le circuit test est multitension, c'est à dire fonctionne de façon fiable dans une plage de tension prédéterminée relativement large.

Selon l'invention, ce but est atteint par le fait que le circuit test comporte un composant électronique à caractéristique non linéaire connecté en parallèle sur ledit enroulement auxiliaire.

Selon un premier développement de l'invention le circuit test comporte une résistance additionnelle, l'enroulement auxiliaire et la résistance additionnelle constituant un circuit série connecté en parallèle sur ledit composant.

Selon un second développement de l'invention, le circuit test comporte un condensateur, l'enroulement auxiliaire et le condensateur constituant un circuit série connecté en parallèle sur ledit composant. Le circuit test est alors simultanément multitension et multifréquence, permettant ainsi au dispositif de protection différentielle d'être utilisé dans tout réseau électrique, quelles qu'en soient la tension et la fréquence.

Selon un mode de réalisation préférentielle, ledit composant a une caractéristique tension/courant telle que l'inéquation suivante soit respectée :

$$2N1.I_{\Delta N} \le N2.I_T \le 2,5N1.I_{\Delta N}$$

où N1 est le nombre de spires d'un enroulement primaire du transformateur-sommateur, N2 le nombre de spires de l'enroulement auxiliaire, $I_T$ la valeur du courant dans l'enroulement auxiliaire et $I_{\Delta N}$ le courant différentiel nominal de déclenchement.

Les avantages et caractéristiques de l'invention ressortiront plus clairement de la description suivante de modes particuliers de réalisation, donnés à titre d'exemples non limitatifs, et représentés aux dessins annexés sur lesquels :

La figure 1 représente un dispositif selon l'art antérieur,
La figure 2 représente un mode de réalisation d'un circuit test multitension d'un dispositif selon l'invention.
La figure 3 illustre les variations, en fonction de la tension d'alimentation du circuit test, du rapport K = N2.IT/N1.$I_{\Delta N}$, dans un dispositif comportant un circuit test selon la figure 2.
La figure 4 représente un mode de réalisation d'un circuit test multitension et multifréquence d'un dispositif selon l'invention.
La figure 5 illustre les variations, en fonction de la fréquence du réseau du rapport entre le courant de test circulant dans l'enroulement auxiliaire à ladite fréquence et le courant de test à 50Hz, dans un dispositif comportant un circuit test selon la figure 4.

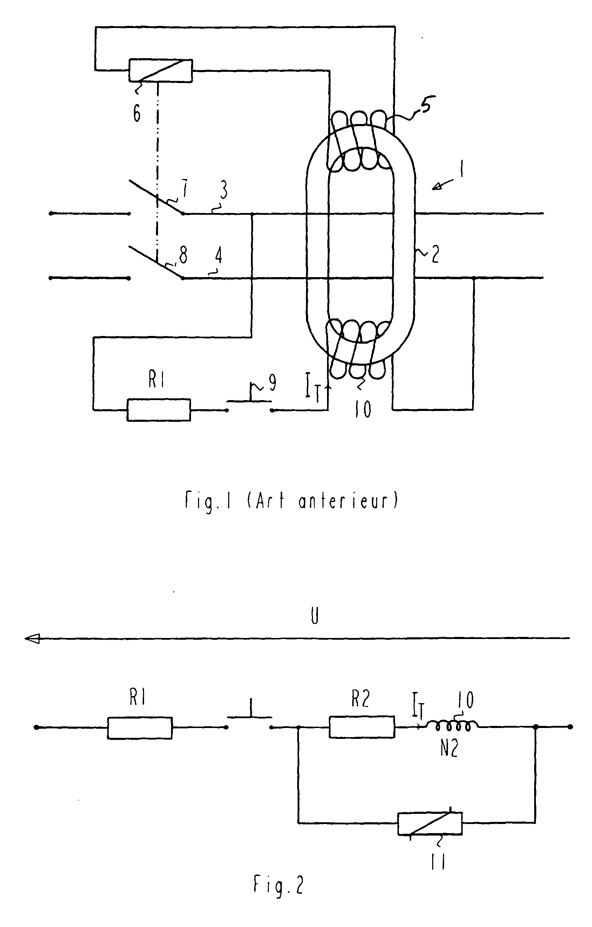

Sur la figure 1, un dispositif de protection différentielle selon l'art antérieur comporte un transformateur-sommateur 1 ayant un noyau 2 en forme de tore traversé par les conducteurs 3, 4 d'un réseau d'alimentation dans lequel est monté le dispositif. Chaque conducteur 3, 4 traverse directement le transformateur ou est enroulé sur le noyau 2 pour former un enroulement primaire ayant un nombre N1 de spires. Le transformateur-sommateur 1 comporte un enroulement secondaire 5 de détection du courant différentiel, connecté aux bornes d'un relais 6.

En l'absence de défaut différentiel, les courants passant dans les conducteurs 3 et 4 sont identiques en valeur absolue et de sens contraire, de sorte que la somme des flux induits dans le noyau 2 est nulle. En présence d'un défaut différentiel, les courants ne sont plus égaux en valeur absolue et lorsque le courant différentiel excède une valeur nominale de seuil $I_{\Delta N}$ prédéterminée, le courant induit dans l'enroulement secondaire 5 provoque l'excitation du relais 6. Celui-ci provoque alors l'ouverture de contacts 7 et 8, respectivement interposés sur les conducteurs 3 et 4.

Le dispositif selon la figure 1 comporte également un circuit test connecté aux conducteurs 3 et 4, de préférence par deux points de raccordement disposés de part et d'autre du noyau 2. Le circuit test comporte, en série, une résistance de test R1, un interrupteur de test constitué par un bouton-test 9, normalement ouvert, et un enroulement auxiliaire 10 du transformateur-sommateur 1.

La fermeture du bouton-test 9 provoque le passage d'un courant de test $I_T$ dans l'enroulement auxiliaire 10 dont la valeur est fonction de la tension U aux bornes du circuit test et de la valeur de la résistance de test R1. Dans le mode de réalisation représenté, la tension U est la tension existant entre les deux conducteurs 3 et 4 du réseau.

N1 étant le nombre de spires de l'un des enroulements primaires formé par l'un des conducteurs 3 et 4 (N1=1 sur la figure 1), $I_{\Delta N}$ le courant différentiel nominal de déclenchement, N2 le nombre de spires de l'enroulement auxiliaire 10, et $I_T$ le courant de test circulant dans l'enroulement auxiliaire ($I_T$=U/R1), les normes imposent que le produit N2.$I_T$ ne dépasse pas 2,5 N1.$I_{\Delta N}$.

Par ailleurs, pour que le circuit test provoque le déclenchement du dispositif lors de la fermeture du bouton test il est nécessaire que N2.$I_T$ soit au moins égal à N1.$I_{\Delta N}$.

Pour une tension U prédéterminée, la résistance de test R1 doit donc être dimensionnée de manière à ce que l'inéquation :

$$N1.\, I_{\Delta N} \leq N2.U/R1 \leq 2.5N1.\, I_{\Delta N} \qquad (1)$$

soit respectée.

Cette condition limite la plage de tension utilisable avec une seule valeur de résistance. En pratique, la conception de dispositifs destinés à être utilisés avec des tensions de 127V, 220V et 415V nécessite deux résistances différentes.

D'autre part, si un courant de défaut existe et si ce courant est en opposition de phase avec celui crée par le circuit test il y a un risque de non déclenchement si la valeur de la résistance R1 est telle que N2. $I_T$ =N1.$I_{\Delta N}$

Pour éviter ce problème, il faudrait idéalement que :

$$2N1.I_{\Delta N} \leq N2.U/R1 \leq 2,5N1.I_{\Delta N} \qquad (2)$$

Cependant, ceci limiterait encore la plage de tension utilisable pour une même valeur de résistance et multiplierait le nombre de circuits tests différents nécessaires pour une gamme de tension donnée.

Le circuit test selon la figure 2 permet de rendre le courant test moins dépendant de la tension, et, en conséquence, de concevoir un circuit test unique, multitension, c'est à dire utilisable de manière fiable, dans une plage de tension étendue.

Le circuit de la figure 2 comporte un composant électronique à caractéristique non linéaire 11 connecté en parallèle sur l'enroulement auxiliaire 10. Un tel composant peut être constitué par une diode Zener, une varistance, une diode de type Transil ou tout autre composant ou combinaison de composants ayant une caractéristique tension/courant non linéaire.

Une résistance additionnelle R2 est, de préférence, connectée en série avec l'enroulement auxiliaire 10, aux bornes du composant à caractéristique non linéaire 11. Les valeurs des résistances R1 et R2 sont choisies de manière à polariser correctement le composant 11 pour un courant au moins égal à 2$I_{\Delta N}$ (pour R1) et à calibrer le courant dans la bobine auxiliaire 10 (pour R2).

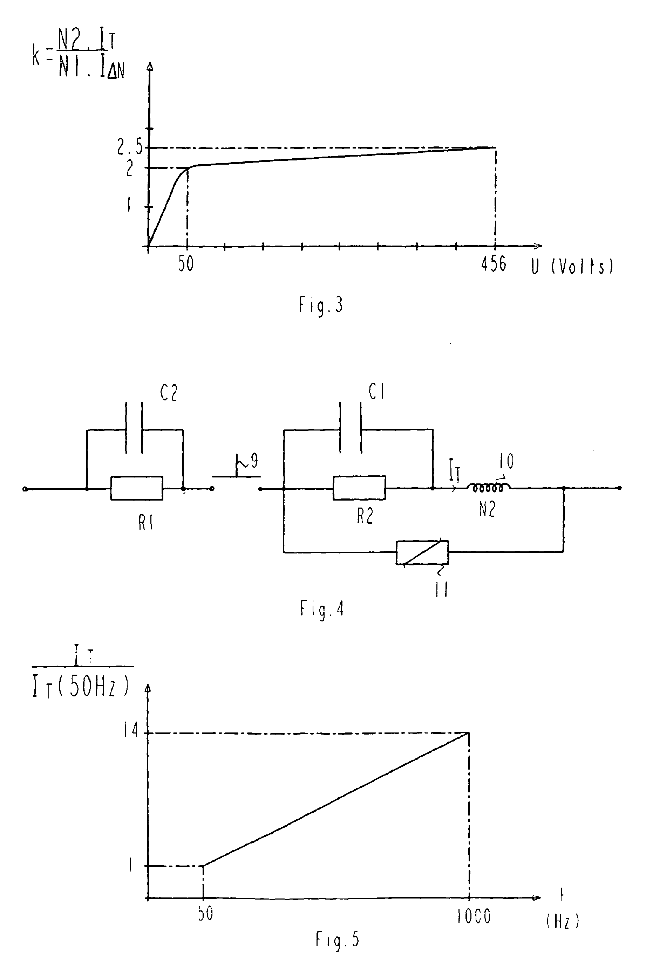

La figure 3 illustre les variations du rapport K=N2. $I_T$ /N1. $I_{\Delta N}$ en fonction de la tension U obtenue dans un mode de réalisation d'un circuit selon la figure 2. En pratique, l'utilisation du composant à caractéristique non linéaire permet d'obtenir un rapport K compris entre 2 et 2,5V, donc satisfaisant l'inéquation (2), pour des tensions comprises entre 50V et 456V.

Le circuit test multitension de la figure 2 permet ainsi non seulement de réduire le nombre de variantes du dispositif de protection différentielle nécessaire, mais également de fiabiliser ce dispositif dans la mesure où il permet d'éliminer les risques de non-déclenchement existant en cas de test lorsque N2.$I_T$ =N1.$I_{\Delta N}$ en présence d'un défaut différentiel.

Dans le mode de réalisation de la figure 4, le circuit test de la figure 2 est complété par l'addition d'un condensateur C1 en série avec l'enroulement auxiliaire 10. Lorsque le circuit test comporte une résistance additionnelle R2, le condensateur C1 est connecté en parallèle sur la résistance R2, comme représenté à la figure 4.

Un tel circuit permet de rendre le courant $I_T$ circulant dans l'enroulement auxiliaire dépendant de la fréquence. Les composants du circuit sont dimensionnés de manière à ce que le rapport entre le courant de test $I_T$ et le courant de test à 50Hz (1 à 50Hz) augmente jusqu'à 14 à 1KHz. La figure 5 illustre la variation, linéaire, de $I_T/I_{T(50Hz)}$ en fonction de la fréquence entre 50Hz et 1 KHz obtenue avec un mode de réalisation du circuit test selon la figure 4.

Un tel circuit test permet de prendre en compte les variations de la sensibilité des dispositifs de protection différentielle en fonction de la fréquence, conformément aux courbes de sécurité. Le même circuit est alors utilisable pour des réseaux de différentes fréquences (50Hz, 400Hz, 1KHz).

Dans un mode de réalisation préférentiel un condensateur additionnel C2 est connecté en parallèle sur la résistance de test R1, de manière à stabiliser la tension aux bornes du composant 11 lorsque le courant $I_T$ augmente avec la fréquence.

Bien que le dispositif représenté sur les figures soit bipolaire, car adapté à un réseau monophasé 3 et 4, l'invention s'applique à tout dispositif de protection différentielle, qu'il soit tripolaire ou tétrapolaire. Dans ce cas, le circuit test est, de manière classique, connecté entre deux des conducteurs d'un réseau triphasé ou tétraphasé. Dans ce cas, le risque de non déclenchement si N2. $I_T$=N1.$I_{\Delta N}$ est encore plus élevé qu'en monophasé en l'absence du circuit test selon l'invention.

Sur les figures le circuit test comporte un seul enroulement auxiliaire (10). Il peut, de manière connue (EP-A-367690) comporter plusieurs enroulements auxiliaires. Dans ce cas, un composant non linéaire peut être disposé en parallèle sur chaque enroulement auxiliaire.

## Revendications

1. Dispositif de protection différentielle comportant un transformateur-sommateur (1), connecté à des moyens (6) de déclenchement, et un circuit test comportant, en série entre deux conducteurs (3, 4) d'un réseau à protéger, une résistance de test (R1), un interrupteur de test (9), normalement ouvert, et au moins un enroulement auxiliaire (10) du transformateur-sommateur (1), dispositif **caractérisé en ce que** le circuit test comporte un composant électronique à caractéristique non linéaire (11) connecté en parallèle sur ledit enroulement auxiliaire (10).

2. Dispositif selon la revendication 1, **caractérisé en ce que** ledit composant comporte une diode Zener.

3. Dispositif selon la revendication 1, **caractérisé en ce que** ledit composant comporte une varistance.

4. Dispositif selon la revendication 1, **caractérisé en ce que** ledit composant comporte une diode de type Transil.

5. Dispositif selon l'une quelconque des revendications 1 à 4, **caractérisé en ce que** le circuit test comporte une résistance additionnelle (R2), l'enroulement auxiliaire (10) et la résistance additionnelle (R2) constituant un circuit série connecté en parallèle sur ledit composant (11).

6. Dispositif selon l'une quelconque des revendications 1 à 4, **caractérisé en ce que** le circuit test comporte un condensateur (C1), l'enroulement auxiliaire (10) et le condensateur (C1) constituant un circuit série connecté en parallèle sur ledit composant (11).

7. Dispositif selon la revendication 6, **caractérisé en ce que** le circuit test comporte une résistance additionnelle (R2) connectée en parallèle sur le condensateur (C1).

8. Dispositif selon la revendication 7, **caractérisé en ce que** le circuit test comporte un condensateur additionnel (C2) connecté en parallèle sur la résistance de test (R1).

9. Dispositif selon l'une quelconque des revendications précédentes, **caractérisé en ce que** ledit composant (11) a une caractéristique tension/courant telle que l'inéquation suivante soit respectée :

$$2N1.I_{\Delta N} \leq N2.I_T \leq 2,5N1.I_{\Delta N}$$

où N1 est le nombre de spires d'un enroulement primaire du transformateur-sommateur (11), N2 le nombre de spires de l'enroulement auxiliaire (10), $I_T$ la valeur du courant de test dans l'enroulement auxiliaire et $I_{\Delta N}$ le courant différentiel nominal de déclenchement.

**Claims**

1. A differential protection device comprising a summing transformer (1) connected to trip means (6), and a test circuit comprising a test resistor (R1), a normally open test switch (9) and at least one auxiliary winding (10) of the summing transformer (1) in series between two conductors (3, 4) of a power system to be protected, a device **characterized in that** the test circuit comprises an electronic component (11) of non-linear characteristic connected in parallel on said auxiliary winding (10).

2. The device according to claim 1, **characterized in that** said component comprises a Zener diode.

3. The device according to claim 1, **characterized in that** said component comprises a varistor.

4. The device according to claim 1, **characterized in that** said component comprises a diode of Transil type.

5. The trip device according to any one of claims 1 to 4, **characterized in that** the test circuit comprises an additional resistor (R2), the auxiliary winding (10) and additional resistor (R2) forming a serial circuit connected in parallel on said component (11).

6. The device according to any one of claims 1 to 4, **characterized in that** the test circuit comprises a capacitor (C1), the auxiliary winding (10) and capacitor (C1) forming a serial circuit connected in parallel on said component (11).

7. The device according to claim 6, **characterized in that** the test circuit comprises an additional resistor (R2) connected in parallel on the capacitor (C1).

8. The device according to claim 7, **characterized in that** the test circuit comprises an additional capacitor (C2) connected in parallel on the test resistor (R1).

9. The device according to any one of the foregoing claims, **characterized in that** said component (11) has a voltage/current characteristic such that the following inequality is respected:

$$2N1.I_{\Delta N} \leq N2.I_T \leq 2,5N1.I_{\Delta N,}$$

where N1 is the number of turns of a primary winding of the summing transformer (1), N2 the number of turns of the auxiliary winding (10), $I_T$ the value of the test current in the auxiliary winding and $I_{\Delta N}$ the rated differential tripping current.

**Patentansprüche**

1. Differenzstromschutzeinrichtung mit einem, mit Auslösemitteln (6) verbundenen Summenstromwandler (1) sowie einer Prüfschaltung, die eine zwischen zwei Leitern (3, 4) eines zu schützenden Netzes angeordnete Reihenschaltung aus einem Prüfwiderstand (R1), einem als Schließer ausgebildeten Prüfschalter (9) und mindestens einer Hilfswicklung (10) des Summenstromwandlers (1) umfasst, welche Einrichtung **dadurch gekennzeichnet ist, dass** die Prüfschaltung ein parallel zur genannten Hilfswicklung (10) geschaltetes elektronisches Schaltungselement mit nichtlinearer Charakteristik (11) umfasst.

2. Einrichtung nach Anspruch 1, **dadurch gekennzeichnet, dass** das genannte Schaltungselement eine Zenerdiode umfasst.

3. Einrichtung nach Anspruch 1, **dadurch gekennzeichnet, dass** das genannte Schaltungselement einen Varistor umfasst.

4. Einrichtung nach Anspruch 1, **dadurch gekennzeichnet, dass** das genannte Schaltungselement eine Breakdown-Diode umfasst.

5. Einrichtung nach einem der Ansprüche 1 bis 4, **dadurch gekennzeichnet, dass** die Prüfschaltung einen zusätzlichen Widerstand (R2) umfasst, wobei die Hilfswicklung (10) und der zusätzliche Widerstand (R2) eine parallel zum genannten Schaltungselement (11) angeordnete Reihenschaltung bilden.

6. Einrichtung nach einem der Ansprüche 1 bis 4, **dadurch gekennzeichnet, dass** die Prüfschaltung einen Kondensator (C1) umfasst, wobei die Hilfswicklung (10) und der Kondensator (C1) eine parallel zum genannten Schaltungselement (11) angeordnete Reihenschaltung bilden.

7. Einrichtung nach Anspruch 6, **dadurch gekennzeichnet, dass** die Prüfschaltung einen parallel zum Kondensator (C1) geschalteten zusätzlichen Widerstand (R2) umfasst.

8. Einrichtung nach Anspruch 7, **dadurch gekennzeichnet, dass** die Prüfschaltung einen parallel zum Prüfwiderstand (R1) geschalteten zusätzlichen Kondensator (C2) umfasst.

9. Einrichtung nach irgendeinem der vorhergehenden Ansprüche, **dadurch gekennzeichnet, dass** das genannte Schaltungselement (11) eine Strom-Spannungs-Kennlinie gemäß folgender Verhältnisgleichung aufweist:

$$2N1.I_{\Delta N} \leq N2.I_T \leq 2{,}5N1.I_{\Delta N,}$$

wobei N1 der Windungszahl einer Primärwicklung des Summenstromwandlers (11), N2 der Windungszahl der Hilfswicklung (10), $I_T$ dem Wert des Prüfstroms in der Hilfswicklung und $I_{\Delta N}$ dem eine Auslösung bewirkenden Nenndifferenzstrom entspricht.

Fig.1 (Art anterieur)

Fig.2

7

$$k = \frac{N2 \cdot I_T}{N1 \cdot I_{\Delta N}}$$

Fig. 3

Fig. 4

$$\frac{I_T}{I_T(50Hz)}$$

Fig. 5

**EP 0 998 003 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1318856
- US 3943409 A
- US 4091431 A
- GB 2269064 A
- EP 367690 A